Europäisches Patentamt

European Patent Office

Office européen des brevets

(11) Publication number: **0 168 983**
**A1**

(12) **EUROPEAN PATENT APPLICATION**

(21) Application number: **85304384.2**

(22) Date of filing: **19.06.85**

(51) Int. Cl.⁴: **G 02 B 21/00, H 01 J 37/244**

(30) Priority: **20.06.84 GB 8415709**

(43) Date of publication of application: **22.01.86**
**Bulletin 86/4**

(84) Designated Contracting States: **AT BE CH DE FR GB IT LI LU NL SE**

(71) Applicant: **IBT-DUBILIER LIMITED, 7, Suffolk Way Drayton Road, Abingdon Oxon, OX14 5JX (GB)**

(72) Inventor: **Sheppard, Colin James Richard, 14(a) Bankside, Headington Oxford (GB)**
Inventor: **Wilson, Tony, 18 Jeune Street, Oxford (GB)**

(74) Representative: **Boydell, John Christopher et al, Stevens, Hewlett & Perkins 5 Quality Court Chancery Lane, London, WC2A 1HZ (GB)**

(54) **Scanning microscope.**

㉗ An optical scanning microscope in which light from a laser source (1) is focussed onto an object (3) and is collected by a detector. The detector has a radiation sensitive area which is split into two parts (6,7) by a dividing line crossing the radiation axis of the microscope. That part of the radiation sensitive area (6,7) which is close to the axis is obscured. Various ways of doing this are discussed in the text; one way is a simple stop (8), such as that shown, which has an annular cut-out, thus giving an effective radiation sensitive area of annular shape. This has been found to improve the imaging performance of the detector.

- 1 -

"SCANNING MICROSCOPE"

This invention relates to scanning microscopes, including electron and acoustic microscopes, and in particular to scanning optical microscopes.

Scanning microscopes comprise a source of radiation, focussing means for focussing radiation onto an object to be viewed, a detector for receiving radiation transmitted through or reflected by the object, and scanning means for scanning the radiation across the object, this latter being achieved by moving the beam of radiation incident onto the object, or the object itself, or both. In an optical microscope, the radiation comprises light which may or may not be from a laser source. This type of microscope is well documented in the literature; see for example Electronics and Power, February 1980, pages 166 to 172. The present invention is concerned particularly with the detection arrangements for such microscopes.

Radiation passing through or reflected by the object is subject to a phase change dictated principally by the height of the object in the direction of the axis of radiation and by the refractive index of the object. It will be seen therefore that changes in the height of the object, for example at the edges of a feature on the object, will give rise to a phase gradient at the detector as the object is scanned. In order to provide good imaging of these phase gradients, particularly abrupt ones due to sharp edges, a small size of detector is needed. However, a small detector is undesirable because it collects only a small fraction of the radiation from the object. One solution to this problem was described by N.H. Dekkers and H. de Lang in OPTIK, 41, pages 452 to 456, (1974) and utilised the technique of differential phase contrast using a split detector. In the split detector, the radiation sensitive area of the detector is split into two equal parts along a line passing through the axis of radiation. In the presence of a phase gradient, the radiation from the object is deflected so that one half of the detector has a larger output than the other. By subtracting the outputs from the two halves of the detector, an image can be built up as the object is scanned. The technique described by Dekkers and de Lang substantially overcame the problems associated with previous methods, but only in respect of electron microscopes. It is only recently that high-quality high-resolution optical images using this technique has been achieved - see D.K. Hamilton and C.J.R. Sheppard, Journal of Microscopy, Vol 133, Pt 1, January 1984, pages 27 to 39.

In the present invention, the imaging performance of the split detector, particularly for scanning optical microscopes, is further improved by providing that the radiation sensitive area does not extend over or close to the axis of radiation. This may be achieved by obscuring that part of the radiation sensitive area of a conventional split detector which is close to the axis or by providing that the detector is designed in the first place in such a way that the area close to the axis is not radiation sensitive - the term "obscured" will be used to indicate both these alternatives. Preferably the obscuration is symmetrical as between the two parts of the detector in order to maintain the overall symmetry of the device. Differences in symmetry which do occur can, however, be compensated for in the output electronics.

The exact manner in which obscuration is achieved varies according to the circumstances. We have examined both circular obscured areas and rectangular obscured areas. In both cases, the centre of the obscured area coincides with the axis of radiation at the plane of the detector.

In practice, four ways of providing the obscured area are possible:-

1) Radiation-opaque mask over the area concerned.

2) Mask of polarising material such as polaroid, as will be explained in more detail below.

3) Provision of a detector with a radiation-sensitive area of suitable shape.

4) Use of an array of detectors, for example photo-diode, CCD, or photo-sensitive arrays or back-scanned arrays to build up an effective sensitive area of suitable shape.

The use of the detector of the invention leads to a number of advantages over the conventional split detector, in particular in improved imaging of weak phase gradients - i.e. where the phase change varies only slowly as the object is scanned - and in a better response at high spatial frequencies - i.e. improved imaging of fine detail.

In order that the invention may be better understood, several embodiments thereof will now be described by way of example only and with reference to the accompanying drawings in which:-

Figure 1 is a very much simplified diagram of one form of scanning microscope, using a split detector;

Figures 2 and 3 show the characteristics of a conventional circular split detector and a rectangular (square) split detector respectively;

Figures 4A and B are diagrams to illustrate the basic technique of the present invention;

Figures 5 to 9 show various configurations of detector according to the present invention, together with their characteristics;

Figure 10 is a diagram of an experimental arrangement consisting of a reflection/transmission microscope utilising the detector of the present invention;

Figure 11 is a series of pictures showing images obtained with the microscope of Figure 10 of a buccal epithelium cell;

Figure 12 are reproductions of CRT line scan displays across A and B, a buccal epithelium cell, and C and D, an air bubble;

Figure 13 is similar to Figure 11, but shows images of an electrical microcircuit;

Figure 14 is a diagrammatic plan view of a detector, showing the operation of a polarising screen;

Figure 15 is a diagrammatic plan view of a four-quadrant detector; and

Figure 16 is a diagrammatic plan view of a special "multi-function" detector.

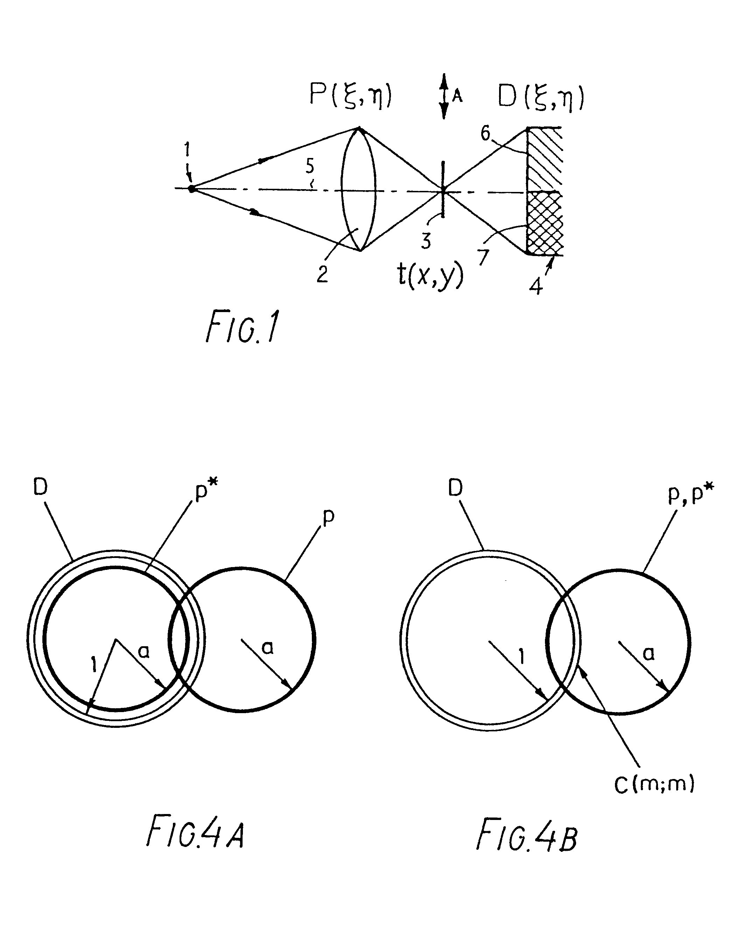

Referring to Figure 1, the basic microscope comprises a radiation source 1 which, in the case of an optical microscope will be a laser source, an objective lens 2, an object 3 to be viewed and a detector 4, all arranged on a common axis 5.

The radiation beam in the object plane is raster scanned relative to the object, as illustrated by the arrowed line A, to build up a picture of the object on an associated television monitor or similar (not shown). This can be achieved by moving the radiation beam in the plane of the object, or mechanically moving the object, or a combination of both.

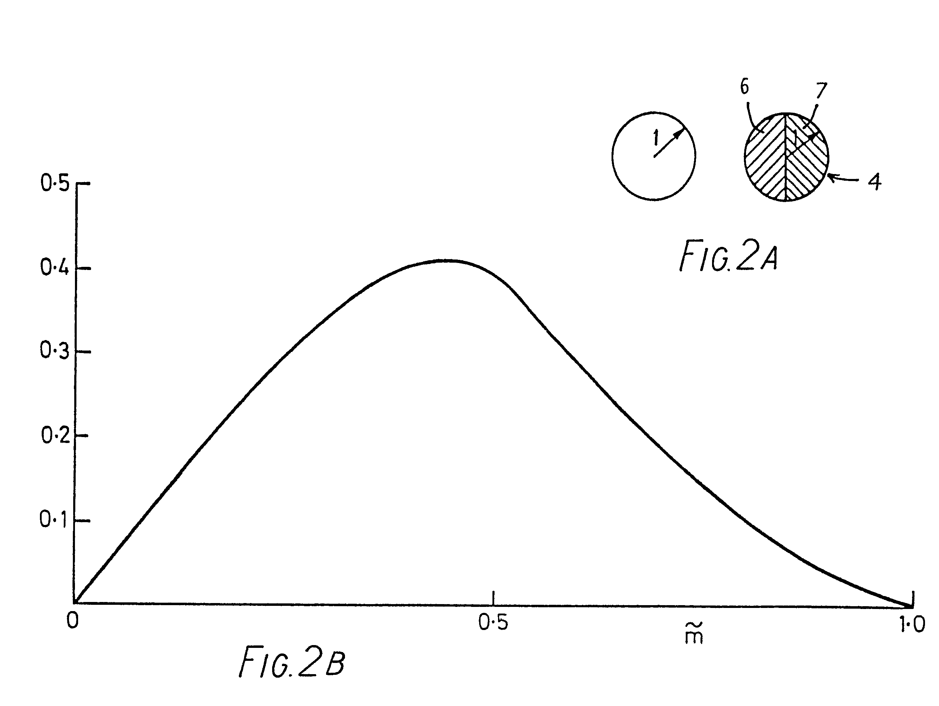

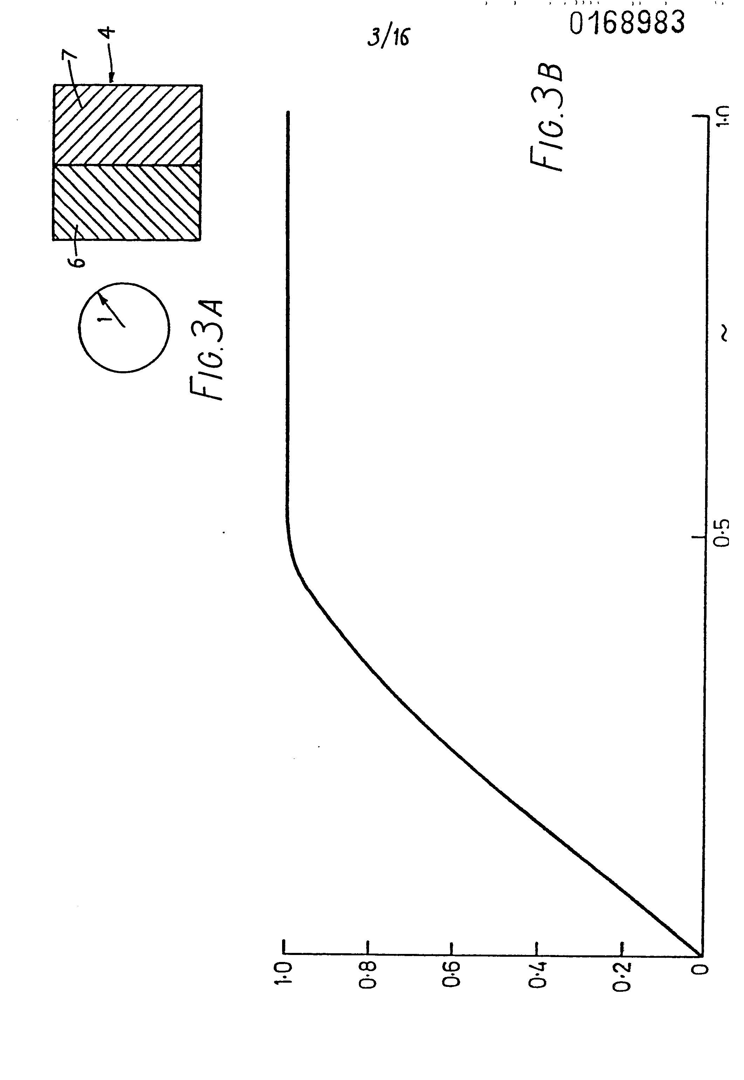

The detector is of the split type, defining two distinct radiation-sensitive surfaces 6 and 7 separated by a line passing through the axis 5 so that the two halves of the detector are symmetrically disposed with respect to the incident beam. The detector surface may be circular, as illustrated in Figure 2A, or rectangular (in this case square), as illustrated in Figure 3A.

Figure 1 shows a transmission type microscope: the characteristics of the radiation changes as it passes through the object and these changes can be detected by the detector to produce an image.  In an alternative arrangement, radiation is reflected off the object and may be detected in the same manner; this technique will be described in more detail later, but the following discussion applies to both types.

The outputs (not shown) from the two halves of the detector are combined and then passed to CRT display apparatus (not shown) whose scanning is synchronised with that of the radiation beam relative to the object.

A scanning microscope with arbitrary detector distribution, such as that shown in Figure 1 forms a partially coherent imaging system, and the image intensity may be written, assuming an object with variations in the axial (x) direction only:-

$$I(x) = \int\int_{-\infty}^{\infty} C(m;p)T(m)T^*(p)e^{-2\pi j(m - p)x}dmdp \qquad (1)$$

where m and p are spatial frequencies in the amplitude transmittance of the object and are the result of phase gradients occuring as radiation is transmitted through or reflected from the object.  T(m) is the Fourier transform of the object transmittance t(x), given by:

$$T(m) = \int t(x)e^{2\pi jmx}dx, \qquad (2)$$

and C(m;p) is the partially coherent transfer function of the system:

$$C(m;p) = \int\int_{-\infty}^{\infty} P(\xi - \tilde{m},\eta)P^*(\xi - \tilde{p},\eta)D(\xi,\eta)d\xi d\eta \qquad (3)$$

where $P(\xi,\eta)$ is the pupil function of the objective lens, $D(\xi,\eta)$ is the detector sensitivity distribution, $\xi$ and $\eta$ are normalised co-ordinates and $\tilde{m}$ and $\tilde{p}$ are normalised spatial frequencies given by, assuming paraxial rays:

$$\tilde{m} = \frac{m\lambda}{\alpha} \qquad (4)$$

$$\tilde{p} = \frac{p\lambda}{\alpha} \qquad (5)$$

where $\lambda$ is the wavelength of the light and $\alpha$ is the semi-angle of convergence of the objective lens 2.

The response of the microscope to two idealised objects is now considered. The imaging of weak objects of the form:

$$t(x) = 1 + t_1(x), \quad |t_1(x)| \ll 1 \qquad (6)$$

is completely characterised by $C(m;0)$, equation (1) reducing to:

$$I(x) = C(0;0) + 2R\ell\left\{\int_{-\infty}^{\infty} C(m;0)T_1(m)e^{-2\pi jmx}dm\right\} \qquad (7)$$

where, in the case of an aberration-free system with a symmetrical split detector $C(0;0)$ is always zero and $C(m;0)$ is real and odd, leading to differential phase contrast. On the other hand, phase gradients of the form:

$$t(x) = e^{j\phi'x} \qquad (8)$$

contain only one spatial frequency component at a frequency $\frac{\phi'}{2\pi}$, and the image is:

$$I(x) = C(\phi'/2\pi ; \phi'/2\pi), \qquad (9)$$

being completely specified by C(m;m). Slowly varying phase gradients result in an image given by the variation of C(m;m) with m. The form of these transfer functions may be calculated from equation (3), as will now be explained.

Consider first the circular split detector shown at the right hand side of Figure 2A, where:

$$P(\xi, \eta) = 1; \; (\xi^2 + \eta^2)^{\frac{1}{2}} \leqslant 1 \qquad )$$
$$\qquad\qquad\qquad\qquad\qquad\qquad\qquad ) \qquad (10)$$
$$\qquad = 0; \; (\xi^2 + \eta^2)^{\frac{1}{2}} > 1 \qquad )$$

and

$$D(\xi, \eta) = \text{sign} (\xi); \; (\xi^2 + \eta^2)^{\frac{1}{2}} \leqslant d \qquad )$$
$$\qquad\qquad\qquad\qquad\qquad\qquad\qquad\qquad ) \qquad (11)$$
$$\qquad = 0; \qquad\qquad (\xi^2 + \eta^2)^{\frac{1}{2}} > d \qquad )$$

where d represents the radius of the split detector normalised to that of the objective lens pupil at the plane of the detector, this latter being represented by the left hand side of Figure 2A. If d < 1, this indicates that the whole of the detector is in the "bright field" region - i.e. receives light directly from the object. If d $\geqslant$ 1 then that part of the detector which lies beyond the pupil size of the objective lens will receive only diffracted and scattered light - the so-called "dark field" region. Equation (11) indicates that the image is formed from the difference of the outputs of the two halves of the detector.

If d > 1 the cut-off of the system transfer function C(m;m) is at a normalised spatial frequency of (1 + d)/2 compared with 1 for C(m;0). If d = 1 then the two functions are identical and are given for positive values of m by Figure 2B which is a graph of the real part of C(m;0) against $\tilde{m}$.

The same comments also apply to the case of the reflection split detector microscope where the extent of the detector is defined by the objective pupil through which the light returns from the specimen, and this transfer function may be written:

$$C(m;0) = C(m;m) = [2\Lambda(\tilde{m}) - \Lambda(2\tilde{m})]\text{sign}(\tilde{m}) \qquad (12)$$

where

$$A(\tilde{m}) = \frac{2}{\pi}\left[\cos^{-1}(\tilde{m}) - \tilde{m}(1 - \tilde{m}^2)^{\frac{1}{2}}\right]. \qquad (13)$$

If the detector pupil is large compared with that of the objective lens ($d \rightarrow \infty$) then $C(m;m)$ is given by:

$$C(m;m) = [1 - \Lambda(2\tilde{m})]\text{sign}(\tilde{m}) \qquad (14)$$

so that for a slowly increasing phase gradient a monotonically increasing signal results. This is shown for a square detector larger than the lens pupil in Figure 3B, which has the same co-ordinates as that of Figure 2B. The weak object transfer function $C(m;0)$ is however identical to that in the previous case for $d = 1$ (see Figure 2B).

In the invention the central part of the sensitive surface of the detector, around the axis of radiation, is obscured. We first consider the effect of obscuring the central part of the detector with a circular stop 8 so that its active area becomes annular in shape and

$$D(\xi,\eta) = \text{sign}(\xi); d_1 \leqslant (\xi^2 + \eta^2)^{\frac{1}{2}} \leqslant d_2$$
$$= 0; \quad (\xi^2 + \eta^2)^{\frac{1}{2}} < d_1 \qquad (15)$$
$$(\xi^2 + \eta^2)^{\frac{1}{2}} > d_2$$

where $d_1$ and $d_2$ are respectively the inner and outer radii of the annular active area.

Still with the optical arrangement of Figure 1, the pupil function may be expressed:

$$P(\xi, \eta) = 1; \quad (\xi^2 + \eta^2)^{\frac{1}{2}} \leqslant a \qquad )$$
$$\qquad \qquad \qquad \qquad \qquad \qquad \qquad ) \qquad (16)$$
$$\qquad = 0; \quad (\xi^2 + \eta^2)^{\frac{1}{2}} > a \qquad )$$

where a is the ratio of the radius of the detector lens pupil at the plane of the detector to the radius of the annulus. In the event that the latter is normalised to unity, then a is effectively the radius of the beam in the plane of the sensitive surface of the detector; its value may be varied in practice by altering the size of the circular stop or by altering the axial position of the detector. We shall consider three idealised cases.

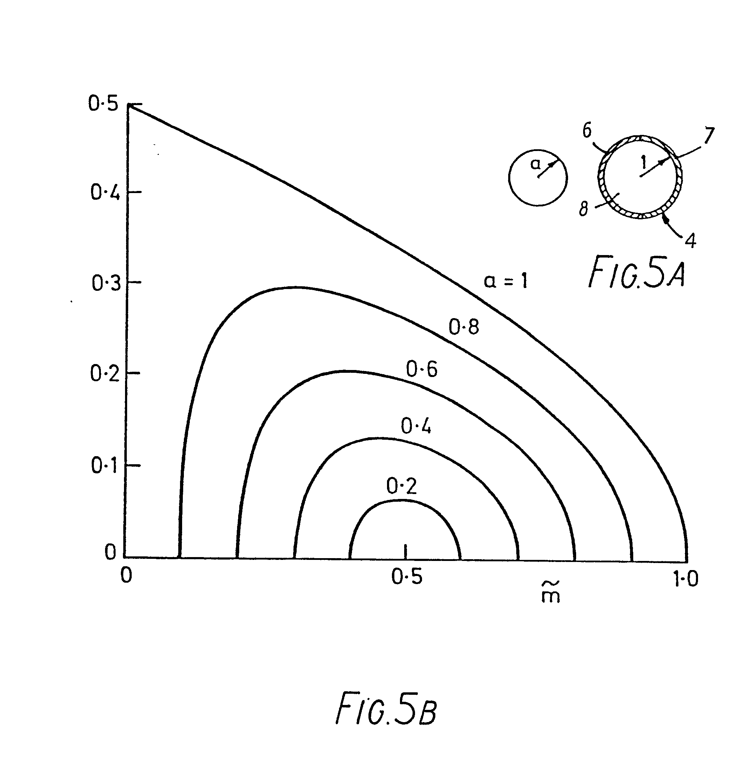

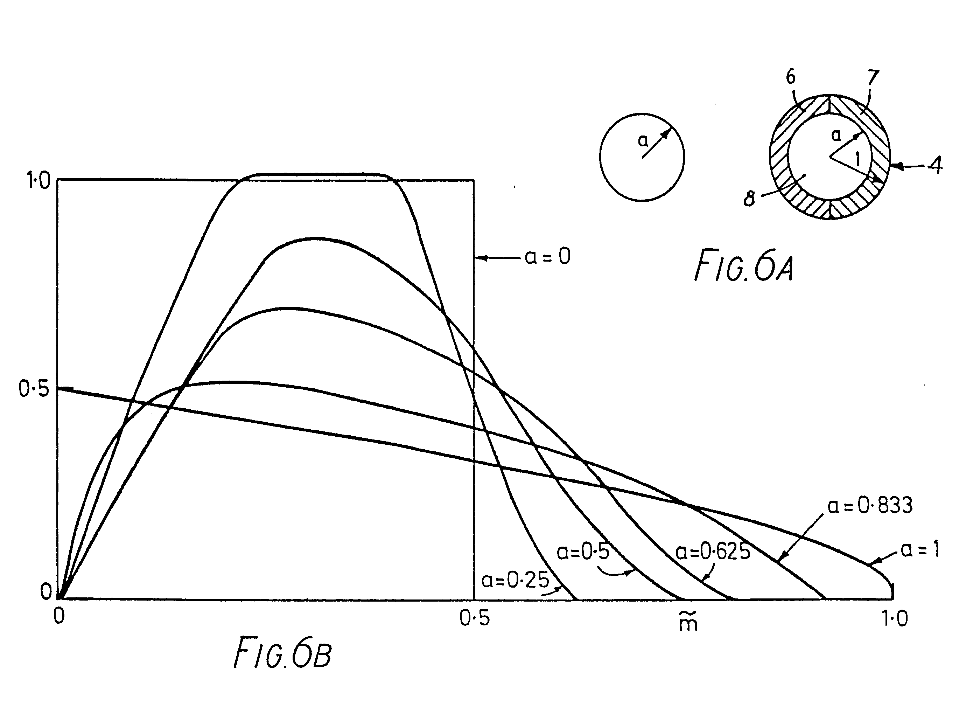

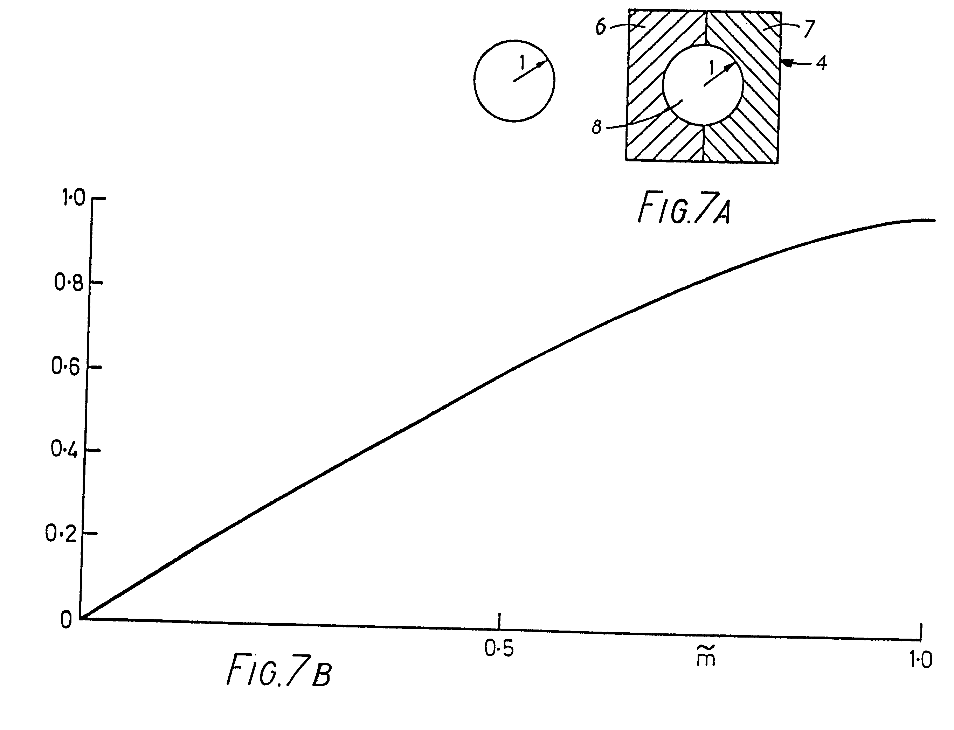

First we consider the case when $d_1 = d_2$, which makes the detector a narrow annulus, and normalise by putting $d_2 = 1$. The areas of integration for equation (4) to evaluate $C(m;0)$ and $C(m;m)$ are shown in Figures 4A and 4B respectively, where it may be seen that for a < 1

$$C(m;0) = 0; \qquad a < 1,$$
$$\qquad \qquad \qquad \qquad \qquad (17)$$
$$\qquad \quad = C(m;m); \; a = 1$$

and

$$C(m;m) = \left[ \frac{1}{\pi}\cos^{-1}(\frac{1 + 4\tilde{m}^2 - a^2}{4\tilde{m}}) \right] \text{sign}(\tilde{m}), \qquad (18)$$

where it should be noted that m is normalised relative to the detector aperture. Equation (18) is plotted for various values of a in Figure 5B. Note that when a = 1, $C(m;0) = C(m;m)$, otherwise $C(m;0)$ is always zero. When these curves are compared with those for the simple split detector in Figure 2B it will be seen

that for $a = d_2 = 1$ the response for low spatial frequencies (i.e. low phase gradients) tends to unity rather than zero, and in addition the response for high spatial frequencies as cut off ($\tilde{m} = 0$) is approached remains higher relative to the mid-frequency value resulting in an improved imaging of high phase gradients (i.e. fine detail). Because of the symmetry of the detector the response at zero spatial frequency (i.e. no phase gradient) drops steeply to zero, the gradient being determined by the thickness of the annulus, resulting in very much improved imaging of small phase gradients. As the radius a of the beam is reduced below 1 the microscope becomes a band-pass system with both low and high frequency cut-offs, the pass-band becoming narrower the smaller the value of a. For the reflection microscope the same transfer functions are obtained; it is possible to vary the value of a in a similar manner by altering the axial position of the detector if the reflected beam is converging (that is, the objective lens has a finite tube length).

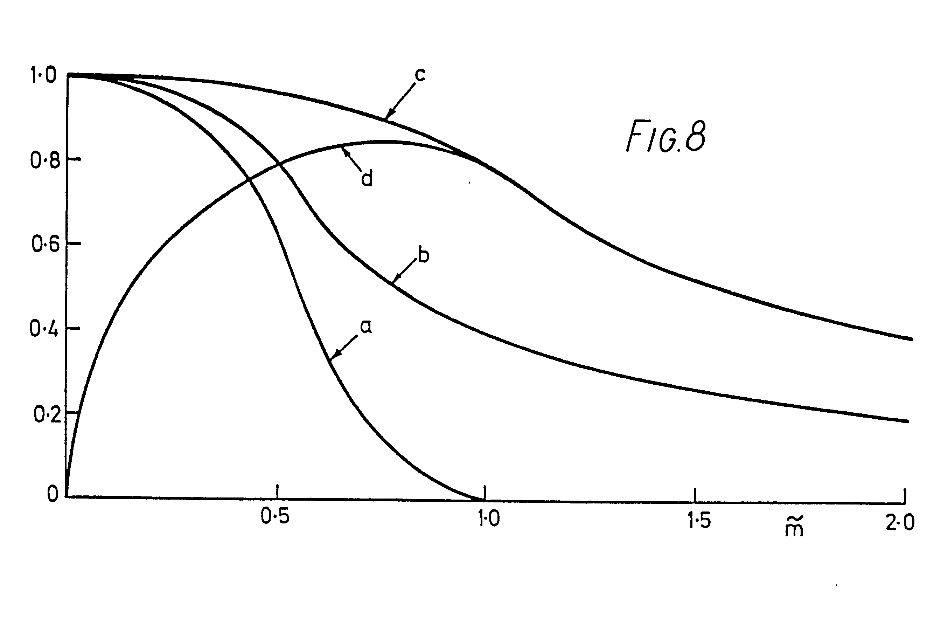

We now consider the case where the radius $d_1$ of the central obstruction is equal to the radius a of the beam and normalise as before by putting $d_2 = 1$ (see Figure 6A). This corresponds to imaging which is just dark field where the detector receives only diffracted and scattered light, thus giving improved contrast in the resultant image. In this case, $C(m;0)$ is always zero. The transfer function $C(m;m)$ is now:

$$C(m;m) = [\Gamma(\tilde{m},a) - \Lambda(\tilde{m}/a)]\,\text{sign}(\tilde{m}) \qquad (19)$$

in which $\Gamma(\tilde{m},a)$ represents the normalised area in common between circles of radii unity and a with centres separated by a distance $2\tilde{m}$. The transfer function $C(m;m)$ is shown in Figure 6B in which it is again seen that for small phase gradients there is a sharp increase in intensity with phase gradient. At the limit a = 1 this case is identical with the corresponding previous case shown in Figure 5B. In practical examples the obstruction is never exactly equal in radius to that of the objective pupil and neither is the annulus infinitely narrow so that in practice the transfer function is somewhere intermediate between those in Figures 5B and 6B. As a general matter, it is found in practice that the width of the annulus ($d_2$ - $d_1$) should preferably be less than about 20% of the outside radius $d_2$ of the annulus for the advantageous features associated with this invention to be achieved.

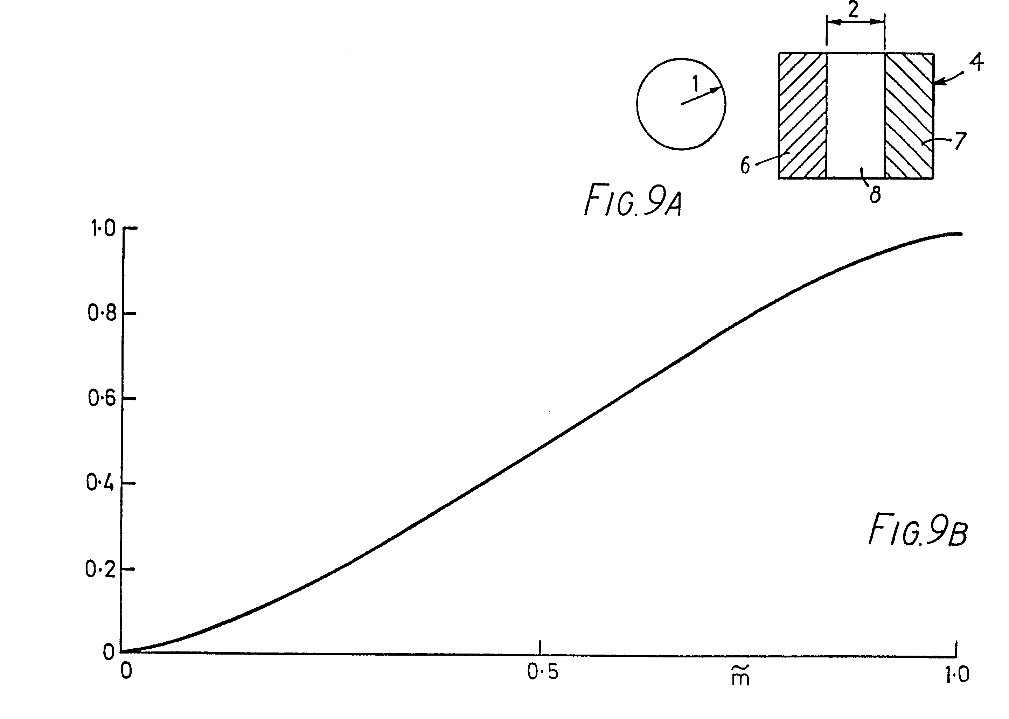

We now consider the case where a and $d_1$ are unity and $d_2$ is large such as shown (for a square detector) in Figure 7A. Again this results in just dark field imaging and C(m;0) is always zero. The spatial frequency is now normalised in terms of the objective lens aperture so that the transfer function given by

$$C(m;m) = [1 - \Lambda(\tilde{m})]\text{sign}(\tilde{m}) \tag{20}$$

and as shown in Figure 7B is no longer directly comparable with those in Figure 5B. It is, however, comparable with those in Figure 2B, which comparison shows the important property of the present arrangement that the transfer function is linear over a greater range of spatial frequencies. Thus if electronic integration is used to give a phase contrast rather than a differential phase contrast image, use of the detector of Figure 7A results in improved images of slowly varying phase structures. This is illustrated in Figure 8 which shows the effective transfer function after integration for such structures against spatial

frequency $\tilde{m}$ for the following four cases:

a - with the detector of Figure 2A

b - with the detector of Figure 3A

c - with the detector of Figure 7A

d - with the detector of Figure 9A (described below).

The change in phase $\Delta \phi_i$ in the image over a distance $\Delta x$ given by:

$$\Delta \phi_i = C(\frac{\phi'}{2\pi}); \frac{\phi'}{2\pi}) \Delta x \tag{21}$$

$$= \left[ \frac{C(\frac{\phi'}{2\pi}; \frac{\phi'}{2\pi})}{\phi'} \right] \Delta \phi \tag{22}$$

so that the effective transfer function for slowly varying phase is:

$$c_{eff}(\frac{\phi'}{2\pi}) = \frac{C(\frac{\phi'}{2\pi}; \frac{\phi'}{2\pi})}{\phi'}, \tag{23}$$

which is normalised to unity at $\phi' = 0$ in Figure 8.

The final detector configuration to be considered is that in which a strip equal in width to the diameter of the objective is used to obscure the central region of the detector. Such an arrangement is shown in Figure 9A. The transfer function is given by:

$$C(m;m) = \left[\frac{1}{2} - \frac{1}{2} \Lambda (1 - 2\tilde{m})\right] \text{sign}(\tilde{m}), \quad |\tilde{m}| \leqslant \frac{1}{2} \quad \left.\begin{array}{c}\\ \\ \\ \\ \end{array}\right)$$

$$\left.\begin{array}{c} \end{array}\right) \tag{24}$$

$$= \left[\frac{1}{2} + \frac{1}{2} \Lambda (2\tilde{m} - 1)\right] \text{sign}(m), \quad |\tilde{m}| > \frac{1}{2} \quad \left.\begin{array}{c}\\ \\ \end{array}\right)$$

and shown in Figure 9B in which it is seen that this is approximately zero for small $\widetilde{m}$, and equal to $\pm$ 1 for $\widetilde{m}$ large positive and negative respectively so that for an object with a wide range of slopes we expect to obtain tone-separated images consisting mainly of black, white and mid-grey. Comparing the arrangements of Figures 7 and 9 with that of Figure 2 we note that contrast is greatest close to those values of slope for which contrast is very weak for the ordinary split detector.

<u>Experimental Observations</u>

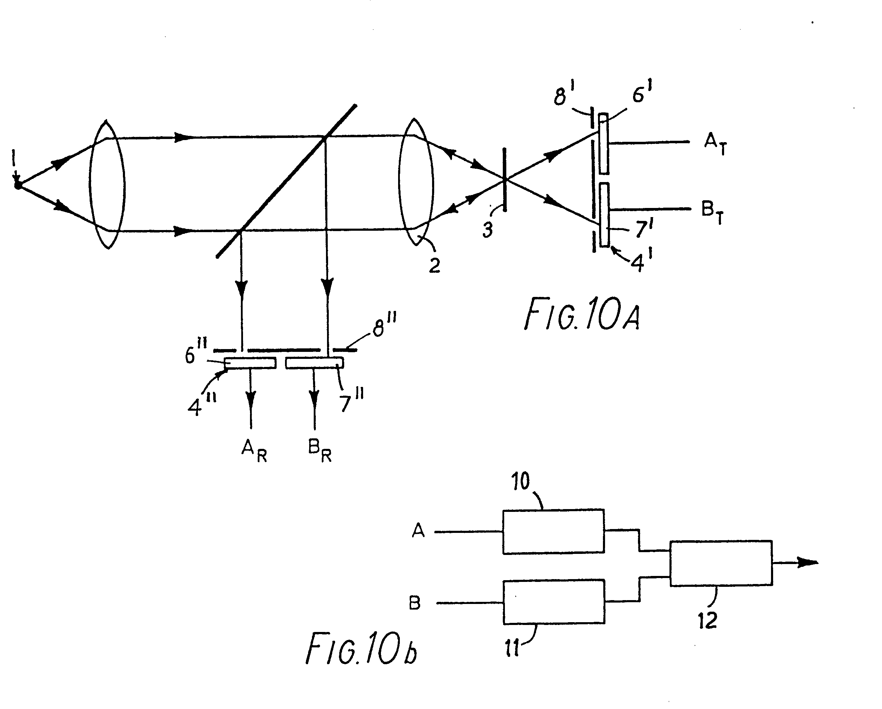

An experimental arrangement shown diagrammatically in Figure 10 was set up to test the obscured detector. Figure 10 shows a scanning optical microscope in which the radiation source 1 is a helium-neon laser giving a coherent light output at a wavelength of 632.8 nm. The experimental set up is arranged to operate both in transmission mode and reflection mode. For the transmission mode, the arrangement is as described previously, with light passing through the object and thence through an annular cut out in a stop 8' before impinging on the sensitive areas 6', 7' of the split detector 4'. Separate outputs $A_T$ and $B_T$ are taken from the two halves of the detector 4' and are amplified in respective amplifiers 10, 11 (see Figure 10B) before being subtracted in a subtraction circuit 12 and thence passed to a television display (not shown) in the manner described previously.

In the reflection mode, light reflected from the object passes back through the objective lens 2 and is thence reflected by a dichroic mirror 13 to a further stop 8" associated with a split detector 4". Outputs $A_R$ and $B_R$ from the two halves 6", 7" of the detector are treated in the same manner as previously described.

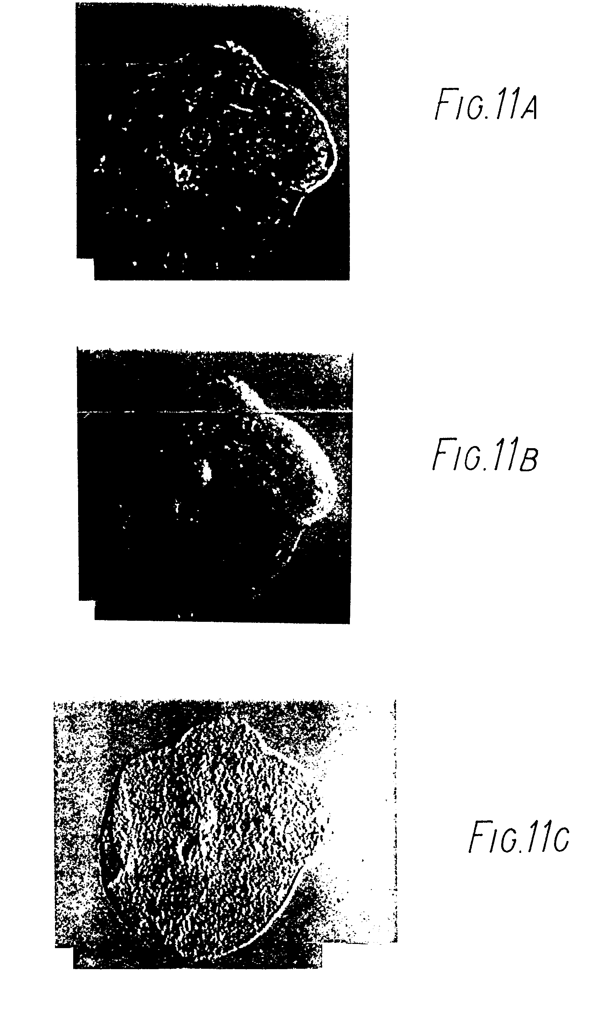

Figure 11 shows three images obtained of the same buccal epithelium cell, fixed in water and mounted conventionally between cover glass and microscope slide. The objective lens used had a numerical aperture of 0.5.

Figure 11A was formed using the large area split detector of Figure 3A and Figures 11B and 11C with the annular split detector of Figure 5A with a = 1 and a = 0.7 respectively. The most striking difference between Figure 11B and the image from the conventional split detector is the presence of information corresponding to small phase gradients (small $\tilde{m}$). This is particularly well shown at the left-hand side of the cell where an increase in thickness is clearly seen, a feature which Figure 11A images hardly at all. There is also gradually changing shading across the whole cell, implying that it is somewhat thicker in the centre than at the edges. These observations can be explained in terms of the transfer function C(m;m) which for the beam just filling the annulus (a = 1) is shown in Figure 5B. When this is compared with C(m;m) for the unobscured split detectors (Figures 2B and 3B) it is clear that the response for smaller phase gradients is more dominant for the annular detector. In Figure 11C, where the beam diameter at the plane of the detector was less than that of the annulus, making C(m;m) zero for small phase gradients, this information has again been suppressed, but stronger high frequency information has continued to be imaged.

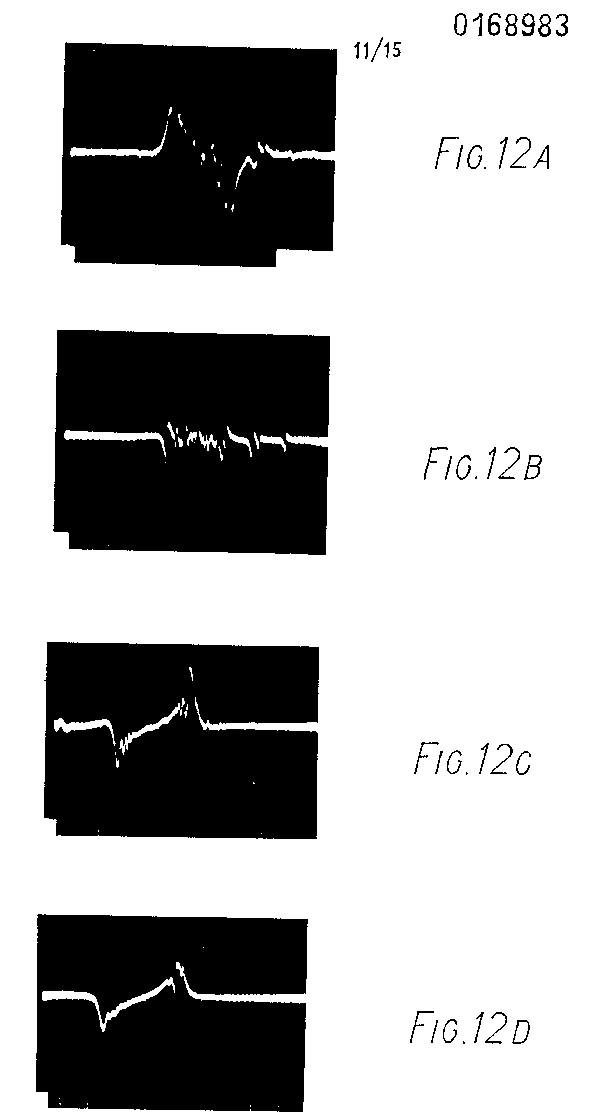

This behaviour is illustrated further in Figure 12, in which A and B show line scans through a similar cell with detector conditions corresponding to Figures 11B and 11C respectively. In Figure 12A the gradual phase variation resulting from the changing optical thickness of the cell is visible but this disappears in Figure 12B as C(m;m) becomes zero for small phase gradients. Figures 12C and 12D are line scans through an air bubble of similar dimensions but very much larger optical thickness, so that phase gradients are proportionally increased above the low spatial frequency cut-off and continue to be imaged in Figure 12D.

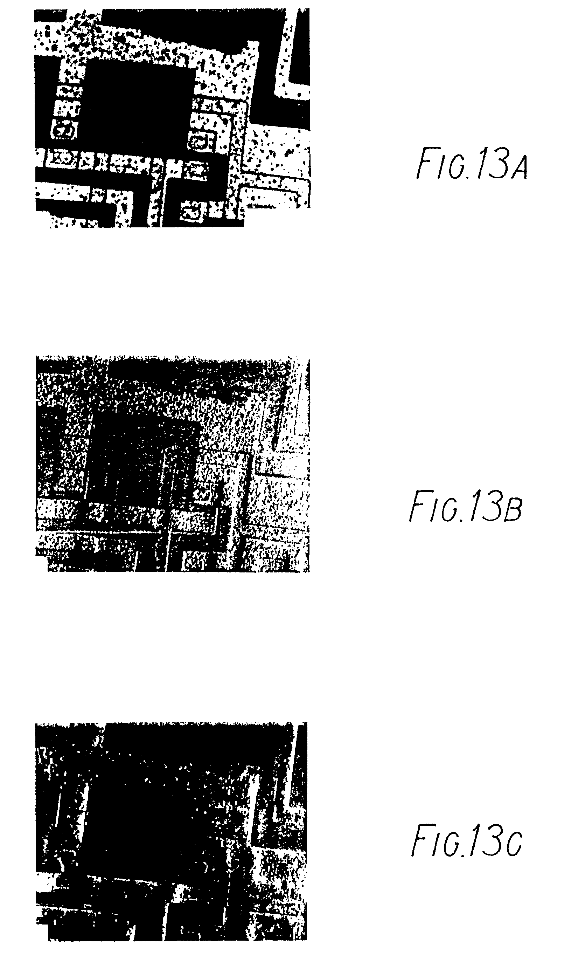

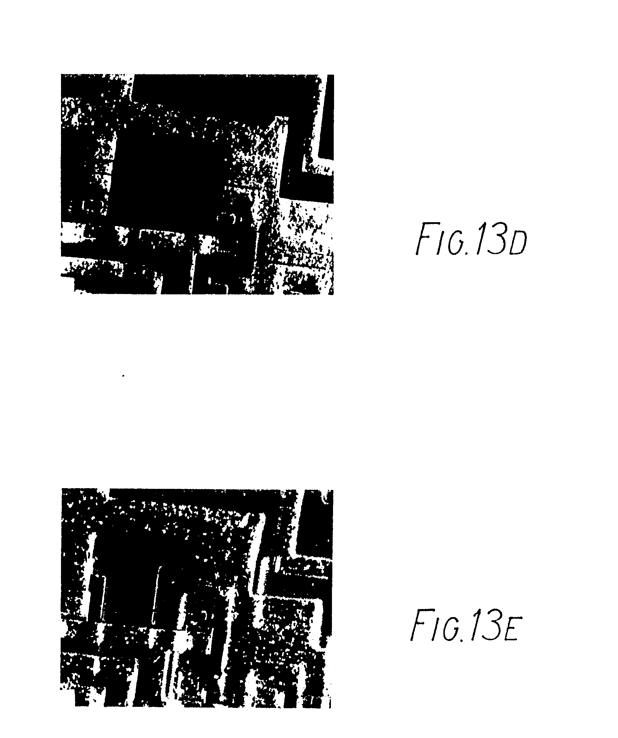

Figure 13 shows images of part of a microcircuit, obtained also with an objective lens having a numerical aperture of 0.5 and with the system in reflection mode. Figure 13A is a conventional reflected light micrograph and Figure 13B is a differential phase contrast image using a large area split detector such as shown in Figure 3A. Figure 13C was produced with the detector configuration of Figure 6A with a $\sim$ 0.7. Strong shading has appeared across the metallised areas of the circuit in the direction of differentiation, revealing that the edges of the metal are in fact rounded. This can again be attributed to the improved relative response to weak phase gradients. If this detector is now displaced a small distance along the direction of differentiation, the resulting image (Figure 13D) can be regarded as a linear combination of the difference and the sum of the two outputs $A_R$, $B_R$ from the detector, and is now composed of the differential phase contrast image with a small amount of the conventional image of Figure 13A superimposed, a useful pictorial combination of both amplitude and phase information. The detector with a central strip obstruction (Figure 9A) gave the image of Figure 13E, which shows the predicted three-level tone-separated characteristic, the slight curvature on the metal surface being imaged strongly black and white, and the almost perfectly flat silicon in between appearing uniformly grey. Fine surface detail within these silicon areas has been particularly well shown up.

An alternative method of blanking off part of the radiation sensitive area in the manner described above will now be discussed.

The most obvious method of observation is the simple provision of an opaque stop, as described in the specific examples illustrated above. By "opaque" in this context is meant impenetrable by the radiation being used, be this light or whatever. A similar effect can be achieved by using a screen made of polarising material such as polaroid placed in front of the conventional split detector. Polarising material is characterised by having a single direction of polarisation and will allow light only of that direction of polarisation to pass through. Laser light, itself being characterised by a direction of polarisation, will then pass through the screen only if the directions of polarisation are aligned.

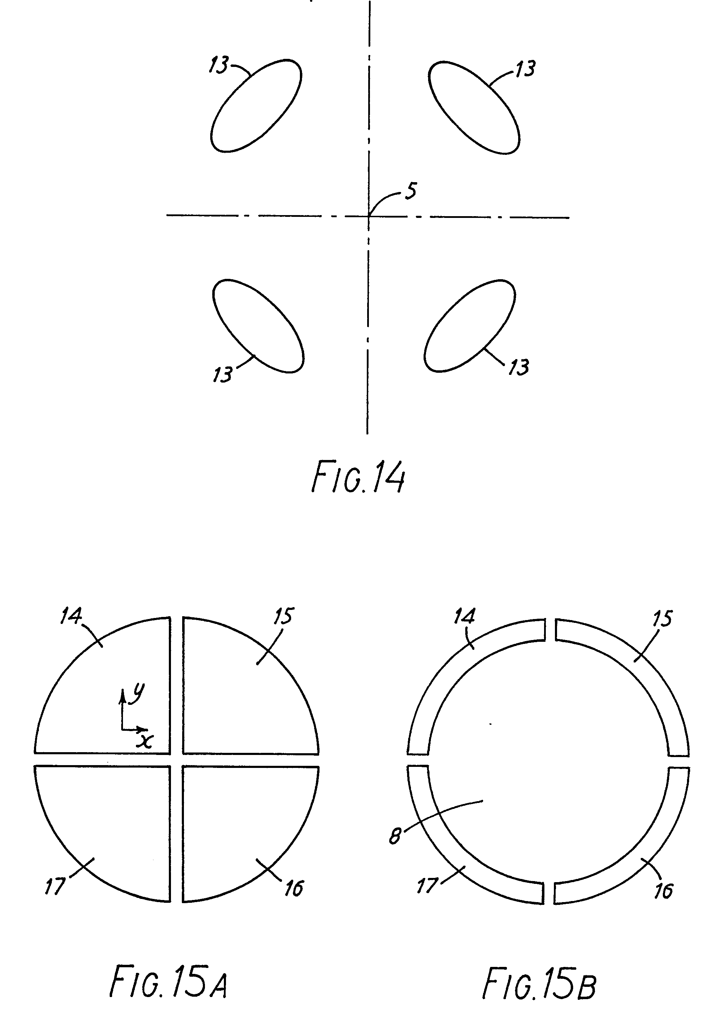

By suitable orientation of a polarising screen with respect to the direction of polarisation of the light beam, an obscuring effect similar to that of an opaque stop can be achieved. The light incident on the detector is, as has been said, polarised in a single direction. On the optical axis, this direction is in a plane parallel to the detector, but those parts of the beam which are spaced from the axis are diverging away from the axis and their directions of polarisation are accordingly inclined to the plane of the detector. Suppose now that a polarising screen is placed in front of the detector and parallel thereto and is such that its direction of polarisation is orthogonal to that of the on-axis beam. In these circumstances, light at or near the axis will fail to pass through the screen whereas light further away from the screen, having an ever larger component in the direction of polarisation, will be able to pass through. In practice, with the arrangement just described, it is found that four distinct areas are defined where a reasonable amount of light is able to pass through, these areas being illustrated diagrammatically in Figure 14 under reference 13. The four areas give the effect of a four-quadrant split detector which will be discussed in more detail below.

Thus far, only a detector having two separate sensitive areas has been discussed. In fact, a number of advantages may be obtained by fabrication of a split detector made up of a plurality of separate sensitive areas arranged as sectors about a circle centred on the radiation axis of the system. In particular, a four quadrant obscured detector, such as is illustrated diagrammatically in plan in Figure 15 has some advantageous features.

The detector illustrated in Figure 15A has four equal-sized sensitive areas 14, 15, 16 and 17. The electrical outputs from each of these areas may be acted upon in various ways to provide various different imaging characteristics at the flick of a switch. For example the outputs of all four quadrants may be combined to give a conventional image with no differential phase contrast. Alternatively, the combined outputs of areas 15 and 16 may be subtracted from the combined outputs of areas 14 and 17 to give the same effect as the detector of Figure 2A - i.e. differential phase contrast in the x-direction. Differential phase contrast in the y-direction may be achieved by subtracting the combined output from areas 16 and 17 from that of areas 14 and 15. By suitable combination of the outputs differentiation in any direction can be achieved.

It will be apparent that such a detector could also be usefully obscured in the manner of the present invention, and an example of such a detector is shown in plan in Figure 15B.

It will be seen that use of various selectively obscured split detector configurations can result in superior imaging of small phase gradients and/or high spatial frequencies. Incorporation of one or more of these in a scanning microscope system would increase the versatility by allowing instant comparison of images displaying different object features.

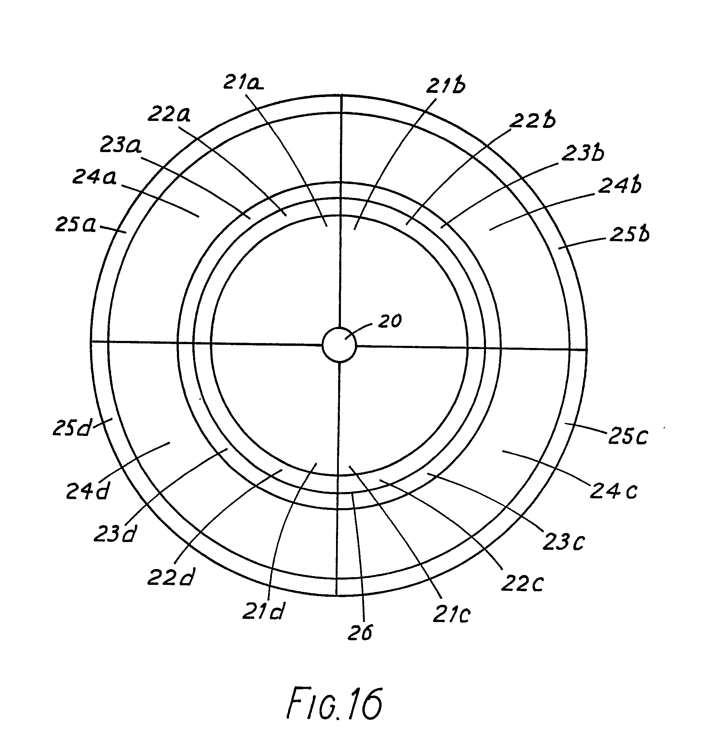

Finally, reference is made to Figure 16 which is a view similar to that of Figure 15, but showing a special detector comprising different areas, some of which possess the features of the present invention and some of which do not. The idea is that switching in the electronics connected to the detector will enable a user to select the area most suitable to his particular requirements as he views the object.

The detector of Figure 16 is circular in configuration, and comprises a small central area 20 surrounded by a plurality of mutually isolated annular areas 21 to 25, each being split, in the manner and for the purpose described with reference to Figure 15, into four quadrants respectively represented by the letters a, b, c and d. The detector is positioned such that its geometric centre is coincident with the axis 5 of the system, and the circular dividing line 26 between areas 22 and 23 is such as to be equal to the radius of the beam in the plane of the detector (i.e. is equal to the ratio a, if it is assumed that the radius of the annulus is unity).

The properties of the different areas have, in the main, already been outlined above, but will be summarised below for convenience:-

Area 20

This central area effectively forms a point detector to provide coherent imaging for direct observation of the object. Such an image is linear in amplitude and it is therefore simple to calculate what the image should be. Coherent imaging is widely used for the metrology of small features.

Area 21

This forms a four-quadrant bright field detector giving a conventional optical image.

Area 22

This forms the bright field annular detector of the present invention, in four quadrant format, and corresponds with the detector arrangement shown in Figure 5A. This area gives improved imaging of weak phase gradients and better response at high spatial frequencies - i.e. fine detail.

Area 23

This forms the dark field annular detector of the present invention, in four quadrant format, and corresponds with the detector arrangement shown in Figure 6A. This area, being beyond the incident beam, collects diffracted and scattered light. This leads to properties similar to those of area 22, but with improved contrast.

Area 24

This forms a full dark field annular detector of the type envisaged by the present invention. The area is arranged to receive scattered light only, giving rise to still further increased contrast resulting in good imaging of fine detail in the object.

Area 25

This forms a scattered light annular detector of the type envisaged by the present invention and is of use in checking for particles on the surface of the object since it collects light scattered through large angles.

The invention is applicable to all types of scanning microscope, but its greatest benefits will be achieved when used with scanning optical microscopes, whether of types 1 or 2 (confocal), or heterodyning or interference microscopes.

## CLAIMS

1. A scanning microscope comprising a source of radiation, focussing means for focussing radiation onto an object to be viewed, a detector having a radiation sensitive area for receiving radiation transmitted through or reflected by the object, said radiation sensitive area being split into two parts having a dividing line passing through the axis of radiation, and scanning means for scanning the radiation across the object, the microscope being characterised in that the detector is such that that portion of the radiation sensitive area which is on or close to the axis of radiation is obscured (as herein defined).

2. A scanning microscope as claimed in claim 1 wherein the centre of the obscured area is on the axis of radiation.

3. A scanning microscope as claimed in claim 2 wherein the perimeter of the radiation sensitive area and the obscured area are both circular and coaxial with one another to give a radiation sensitive area of annular shape.

4. A scanning microscope as claimed in claim 3 wherein the width $(d_2-d_1)$ of the annular radiation sensitive area is less than about 20% of the outside radius $(d_2)$ of the annular radiation sensitive area.

5. A scanning microscope as claimed in claim 2 wherein the perimeter of the radiation sensitive area and that of the obscured area are both rectangular in shape and in registry with one another.

6. A scanning microscope as claimed in any one of the preceding claims wherein the radiation is in the optical range.

$P(\xi, \eta)$   A   $D(\xi, \eta)$

$t(x,y)$

FIG.1

FIG.4A

FIG.4B

FIG.2A

FIG.2B

Fig.3A

Fig.3B

0168983

*FIG.5A*

*FIG.5B*

FIG.6A

FIG.6B

FIG.7A

FIG.7B

FIG.8

0168983

FIG.9A

FIG.9B

FIG.10A

FIG.10b

*FIG.11A*

*FIG.11B*

*FIG.11C*

FIG.12A

FIG.12B

FIG.12c

FIG.12D

FIG.13A

FIG.13B

FIG.13c

*FIG.13D*

*FIG.13E*

0168983

*FIG.14*

*FIG.15A*

*FIG.15B*

0168983

FIG.16

**European Patent Office**

**EUROPEAN SEARCH REPORT**

Application number

EP 85 30 4384

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | APPLIED OPTICS, vol. 23, no. 2, 15th January 1984, pages 348-352, Optical Society of America, New York, US; D.K. HAMILTON et al.: "Two-dimensional phase imaging in the scanning optical microscope" * Whole document * | 1,2,6 | G 02 B 21/00 H 01 J 37/244 |
| X | ULTRAMICROSCOPY, vol. 2, 1977, pages 251-267, North-Holland Publishing Co.; H. ROSE: "Nonstandard imaging methods in electron microscopy" * Pages 262-263 * | 1,2 | |
| X | GB-A-2 126 778 (E.F.P. MAHER) * Abstract; claims 1,2,12-14 * | 1 | TECHNICAL FIELDS SEARCHED (Int. Cl.4) |
| A | GB-A-2 019 691 (PHILIPS) * Abstract; figures * | 1,3 | G 02 B H 01 J |
| A | FR-A-2 300 414 (C.G.R.-MEV) * Claims 1-4; figures * | 3 | |
| A | US-A-3 908 124 (H.H. ROSE) * Abstract; figures * | 2,3 | |

The present search report has been drawn up for all claims

| Place of search THE HAGUE | Date of completion of the search 18-09-1985 | Examiner KOCH O |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82